# EUROPEAN PATENT APPLICATION

(11) **EP 4 722 661 A1**
(43) Date of publication of application: **08.04.2026**
(21) Application number: 25205585.0
(22) Date of filing: 30.09.2025
(51) Int. Cl.: G01F 1/34, G01F 1/66, G01F 15/00

(54) **DETECTION AND MEASUREMENT OF TRANSIENT PRESSURE EVENTS**

(30) Priority: 04.10.2024 US 202418907351
(71) Applicant: ITRON, INC., Liberty Lake, WA 99019 (US)
(72) Inventor: DARRAS, Amaud, Liberty Lake, 99019 (US); VAGO, Stephane, Liberty Lake, 99019 (US); CARRÉ, Patrice, Liberty Lake, 99019 (US); DURY, Herve, Liberty Lake, 99019 (US)
(74) Representative: Morrall, Jonathan Ian McLachlan

(57) **Abstract**

Detection and measurement of transient pressure events in a water (or other fluid) supply system are described herein. A water meter may have upstream and downstream piezo transducers that measure flowrate and overall water consumption. The transducers operate for very short periods (e.g., milliseconds) at intervals (e.g., a second). During the substantial periods during which the piezo transducers are not measuring flowrate, one of the transducers may be used to detect transient pressure events. An output signal of the transducer is compared to a pressure threshold to determine if a transient pressure event has occurred. The comparison may include either a number of times that the threshold was exceeded during a time period, or the time that the threshold was exceeded during the time period. If a transient pressure event was detected, a dedicated transient event sensor can be turned on to better assess the situation.

## Description

### BACKGROUND

Transient pressure events-or pressure spikes-are a problem in water delivery systems, such as public water utilities. Transient pressure events can cause infrastructure fatigue and damage, pipe breakage, water damage, and other financial expenses.

### BRIEF DESCRIPTION OF THE DRAWINGS

The detailed description is described with reference to the accompanying figures. In the figures, the left-most digit(s) of a reference number identifies the figure in which the reference number first appears. The same numbers are used throughout the drawings to reference like features and components. Moreover, the figures are intended to illustrate general concepts, and not to indicate required and/or necessary elements.
FIG. 1 is a block diagram showing portions of a water delivery system, such as a municipal water utility, configured for the detection and measurement of transient pressure events.
FIG. 2 is a diagram showing portions of a water meter configured for the detection and measurement of transient pressure events.
FIG. 3 is a flowchart showing example operation of a water meter configured for the detection and measurement of transient pressure events.
FIG. 4 is a flowchart showing example operations of alternative types of sensors that may be used to perform transient pressure event sensing.
FIG. 5 is a flowchart showing example operation of a metering device, wherein a transient event sensor is utilized to sense (absolute, relative to atmospheric, and/or gauge) pressure values, and to compare those values to values associated with threshold values of: a count of events; a duration of event(s); and/or a magnitude of events.
FIG. 6 is a flowchart showing example operation of a metering device, wherein two techniques for signal processing are described.
FIG. 7 is a flowchart showing example operation of a metering device, wherein a transient signal sensor and associated logic are used to create and process a digital signal.
FIG. 8 is a flowchart showing example operation of a metering device, wherein two techniques are described to determine a direction of travel of a transient signal.

### DETAILED DESCRIPTION

### Overview

Techniques for the detection and measurement of transient pressure events in a water supply system, such as a municipal water utility, are described herein. The transient pressure events may include both over-pressure and under-pressure events, as well as pressure waves that include both over-pressure and under-pressure portions. The water supply system is representative of fluid supply systems generally, including water, natural gas, propane gas, steam, oxygen, etc. Accordingly, the systems, devices, methods, and/or techniques discussed herein can be applied to fluid systems in a generalized manner. Moreover, references to water may be considered to be references to fluids generally.

Within such a water supply system, a "static" (no moving parts) water meter may have upstream and downstream piezo transducers that measure flowrate, and thereby enable the calculation over time of water consumption. In an exchange of signals between the two transducers, a difference in the time-of-flight of the upstream-directed and downstream-directed signals may be detected. That time difference, together with the distance of travel, can be used to determine the flowrate of water in a water meter. The flowrate is measured by the exchange of signals at intervals over time (e.g., a second). The exchange of signals is completed in a very short period (e.g., milliseconds). Accordingly, the upstream and downstream piezo transducers may be idle for a substantial percentage of the time.

During those idle periods, during which the piezo transducers are not measuring flowrate, one or more of the transducers (e.g., either the upstream or downstream piezo transducer) may be used to detect transient pressure events. In an example, an output signal (i.e., a voltage) of a flowrate transducer may be examined to determine if a transient pressure event occurred. The output of the transducer is a voltage value that changes in an analog manner as the pressure changes. This voltage can be compared to a reference voltage, such as by a low-power voltage-comparator hardware device. The reference voltage may be set at a level indicating a transient pressure event of a concerning magnitude.

Alternatively or additionally, a transient pressure event may be characterized by one or more of: a number of events during a first test period where the signal exceeded a first threshold; a cumulative duration during a second test period during which the signal exceeded a second threshold; and a magnitude by which the signal exceeded a third threshold during a third test period. One or more of the thresholds values and/or test period time-durations may be the same or different, and may be set according to the characteristics of particular design requirements.

In a further example, if a transient pressure event was detected, a (typically) higher-power-consuming transient event pressure sensor may be turned on, to better assess the situation. The transient pressure event sensor may include differences and/or advantages over using the flowrate transducers to detect transient pressure events. In an example, the transient pressure event sensor may be specialized in sensing particular frequencies useful in detecting transient pressure events. In a further example, the transient event sensor may be configured to detect an absolute pressure and/or a relative pressure (relative to atmospheric pressure) and/or a "gauge" pressure value.

### Example System and Techniques

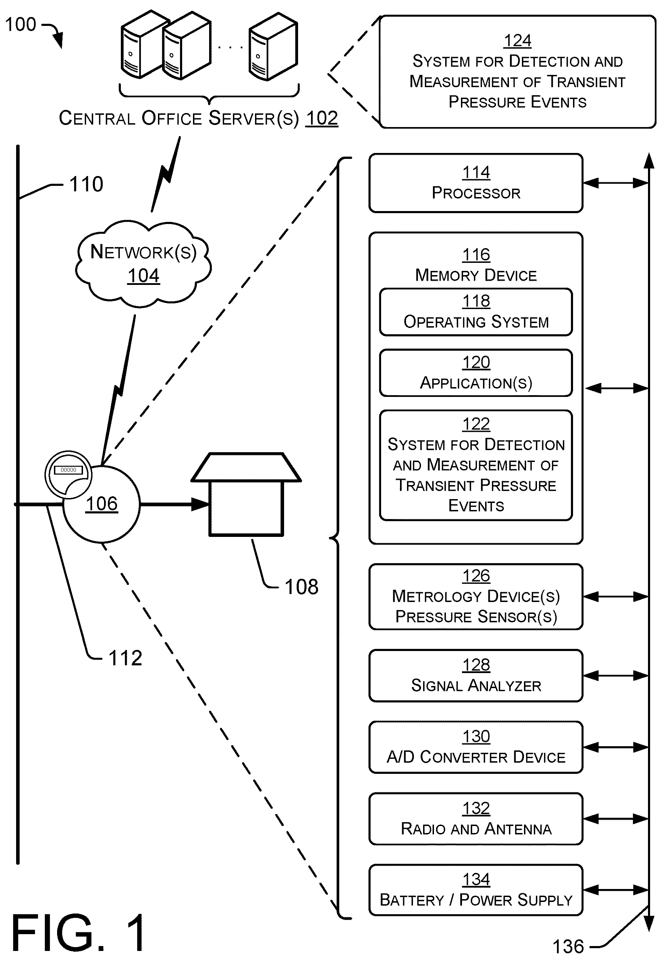

FIG. 1 shows portions of an example water supply system 100, such as a municipal water utility. The water supply system 100 is representative of other fluid delivery systems, such as natural gas, propane, steam, oxygen, etc. Accordingly, the techniques described herein are generally applicable to fluid delivery systems. The water supply system 100 is configured for the detection and/or measurement of transient pressure events. The detection and/or measurement of transient pressure events may be implemented either at the water meter level, or in some instances some of the functionality may be implemented at the water utility company server level, and/or at the "cloud" level.

The example water supply system 100 includes central office (e.g., cloud) computers and/or servers 102 and communications networks 104. The networks 104 may include one or more of the internet, utility company proprietary network(s) using radio, mesh networks, star networks, powerline communications networks, etc.

A utility meter 106 serves a customer site 108, and is representative of many such meters and sites, which may number in the thousands, hundreds of thousands, or millions. In the example shown, the meter is a smart meter and is in communication with the central office server(s) 102 through the network 104. A water main 110 is configured to serve one or more customers connected by an individual pipe 112.

In the example shown, the smart utility meter 106 includes a processor 114 and memory device 116. The memory device 116 may include software programs, that when executed by the processor 114, perform useful functions. In the example of FIG. 1, an operating system 118 and one or more applications 120 are shown.

A system 122 for detection and measurement of transient pressure events is typically located on the smart utility meter 106. Alternatively, system 124 for detection and measurement of transient pressure events may be located on the server(s) 102. The functionality of the system for detection and measurement of transient pressure events may be distributed between the smart utility meter 106 and the server(s) 102. For purposes of illustration, FIG. 1 shows both examples, wherein the system 122 is located on the smart utility meter 106 and system 124 is located on the server(s) 102. The examples discussed here describe systems 122 and 124 that are with reference to water supply. However, corresponding systems could be constructed for use with natural gas or other fluid. Accordingly, the techniques described herein-while they may be explained from the perspective and terminology of water-may be applicable for other measured commodities.

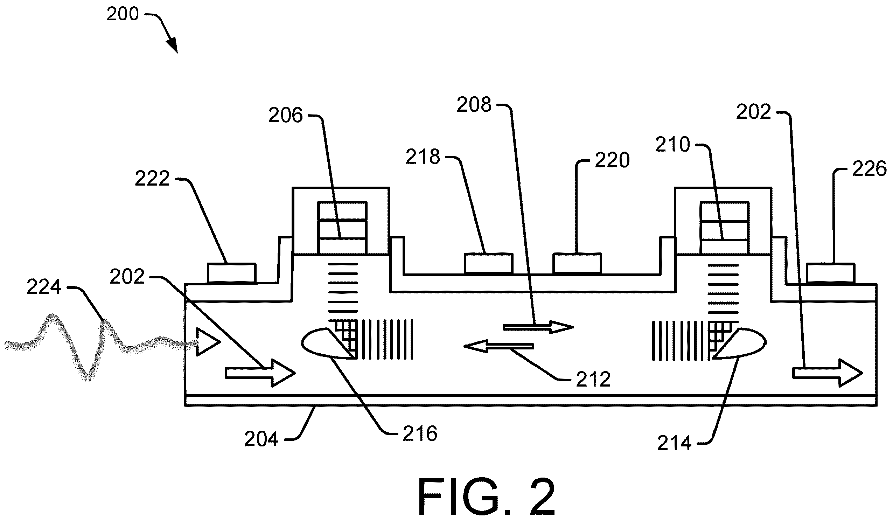

The smart meter 106 may include metrology device(s) 126, which measure consumption of water. The metrology devices 126 are described in greater detail in the discussion of FIG. 2.

The smart meter 106 may contain a signal analyzer 128. The signal analyzer may be a voltage comparator-configured to receive input from one or more sensors-that determines if a transient pressure event occurred. In different examples, the signal analyzer 128 may include and/or be assisted by the processor 114, an application 120, an application specific integrated circuit (ASIC), analog to digital (A/D) converters, or other logic devices (timers, counters, etc.).

In one example, the signal analyzer 128 may be a very low power voltage comparator. The voltage comparator receives input including a voltage value output by a sensor (e.g., included among the metrology device(s) 126), which is compared to a threshold voltage. In an example, if the threshold is exceeded a transient pressure event occurred. In a more complex implementation, the comparison may involve determining: a number of events during a test period during which the signal exceeds the pressure threshold; a cumulative time during the test period during which the signal exceeds the pressure threshold; and/or a magnitude by which the signal exceeds the pressure threshold. Timers, counters, and other logic may be present in the signal analyzer to perform these actions.

In a second example, the signal analyzer 128 may be defined within software applications 120 or an ASIC, and may be configured to recognize a transient pressure event in digital data output from an A/D converter. In an example, an analog to digital converter, A/D converter 130, may be used to process one or more signals from the metrology unit, such as output of a flowrate sensor or a transient event sensor. Once digitized, the digital data may be analyzed by the processor, software, ASIC, or other logic device(s) to determine if a transient pressure event has occurred.

The smart meter 106 may include a radio and antenna 132. The smart meter 106 may also include a battery and/or a power supply 134. A power supply is configured to provide regulated direct current (DC) power at prescribed voltage levels for operation of the processor 114, the memory device 116, the metrology device(s) 126, signal analyzer 128, A/D converter 130, the radio 132, and/or other devices. A bus, printed circuit board, wiring harness, and/or other circuit connectivity device(s) 136 may be used to connect the processor 114, the memory device 116, the metrology devices 126, the signal analyzer 128, the A/D converter device 130, the radio 132, and the power supply 134.

### Example System and Techniques

FIG. 2 shows portions 200 of a water meter (e.g., water meter 106 of FIG. 1) and metrology device(s) 126 configured for flowrate measurement and the detection and measurement of transient pressure events. A flowrate of water 202 is measured as it flows through a pipe 204. An upstream piezo transducer 206 sends an ultrasonic signal 208 to a downstream piezo transducer 210. Similarly, the downstream piezo transducer 210 sends an ultrasonic signal 212 to the upstream piezo transducer 206. Either transmission may briefly precede the other, or the transmissions may be simultaneous (e.g., overlapping, at least in part, in time). The signals 208, 212 may optionally be reflected by mirrors 214, 216 as they travel. The signals 208, 212 are then received by the downstream transducer 210 and the upstream transducer 206, respectively. The time-of-flight of each signal 208, 212 is measured. While the distance traveled by each signal is the same, the time-of-flight is slightly different, due to the flowrate of the water 202. The flowrate of the water (assuming the water is moving) can therefore be determined by analysis of the two different times-of-flight.

In the example of FIG. 2, the operation of the upstream transducer 206 and the downstream transducer 210 may be controlled by flowrate calculation electronics 218. In an example, the flowrate calculation electronics 218 may include one or more hardware metrology device(s) 124, one or more software applications 120, as well as actions of the processor 114, the memory device 116, the operating system 118, etc. In an alternative example, the flowrate calculation electronics 218 may be a dedicated application specific integrated circuit (ASIC), or other device.

The measurement process, wherein the flowrate is measured, may take a few milliseconds, and may be repeated approximately once per second. These times are determined by a mix of factors, including the need for flowrate measurement accuracy and the need for longevity of the battery of a fluid meter, such as a water meter. Since the upstream and downstream piezo transducers perform their flowrate function in only milliseconds every second, either or both transducers are available for other functions when not involved in flowrate measurement.

In an example of techniques for the detection and measurement of transient pressure events, one of the flowrate sensors (e.g., the upstream sensor 206) may be operated by a transient pressure event controller electronics 220 when the flowrate sensors are not functioning to measure the flowrate. Accordingly, the transient pressure event controller electronics 220 operates the upstream sensor 206 during times when it is not used to measure flowrate. During the times the upstream sensor 206 is not actively measuring flowrate, the transient controller electronics 220 uses the sensor to "listen" for transient pressure events. That is, the transient controller electronics 220 monitors an output signal of the upstream sensor 206 to identify a transient pressure event 224. The transient controller electronics 220 may be instantiated within the metrology device(s) 126, the processor 114, or other location depending on design requirements, preferences, and/or costs, etc. Additionally, the flowrate calculation electronics 218 and transient pressure event controller electronics 220 may be unified and/or combined with other electronics.

In some implementations, the flowrate sensors 206, 210 are designed to be efficiently stimulated at the frequency of the time-of-flight signals 208, 212, which are in the ultrasonic range. Transient pressure events may be much lower in frequency. However, the transient pressure events controller electronics 220, using input from one or both of the flowrate sensor(s) 206, 210 may be able to sense a transient pressure event despite being optimized for ultrasonic frequencies.

If the transient pressure event controller electronics 220-using input from the upstream sensor 206 (or the downstream sensor 210)-is able to detect a possible transient pressure event 224 then the controller electronics 220 may activate a transient event sensor 222. Alternatively, the flowrate sensor(s) may continue to be used to detect transient events, with or without assistance of a transient event sensor 222.

The transient event sensor 222 is controlled by electronics 220, the processor 114 and software application(s) 120, etc. The transient event sensor 222 is configured to detect a transient pressure event 224 (i.e., a positive or negative "pressure spike"). Accordingly, operation of the transient event sensor 222 and transient pressure event controller electronics 220 will be able to detect further transient event(s) 224 if present. In many cases, the transient pressure event 224-detected by a flowrate sensor-will be followed by other transient pressure events, which are detected by the operation of the transient event sensor 222 and transient pressure event controller electronics 220. The magnitude of these events, their frequency, times, etc., may be recorded by the transient pressure event controller electronics 220.

The transient pressure event controller electronics 220 may activate a second transient event sensor 226. If the second transient event sensor 226 is separated by a distance from the transient event sensor 222 (as seen in FIG. 2), a comparison of the arrival time (at each sensor 222, 226) of a transient pressure event 224 may be used to determine a direction of travel of the transient pressure event. For example, if the transient event sensor 222 registers the transient event before the second transient event sensor 226, then the transient event may have originated upstream. Referring to FIG. 2, upstream events (which caused the transient spike) may be in the water supply system, while downstream events may be within the customer's site. Determination of the location of the cause of the transient pressure event is helpful to determine a remedy for the cause of the transient pressure event.

While FIG. 2 shows the flowrate calculation electronics 218 and the transient pressure event controller electronics 220 as separate devices, they may be combined into a single device and/or their functionality may be performed by one of, or a combination of, the processor 114, memory device 116, an ASIC, and/or metrology devices 124 of FIG. 1.

### Example Methods

In some examples, the techniques discussed herein may be implemented by one or more processors accessing software defined on one or more memory devices. The processor(s) and memory device(s) may be located on a fluid (e.g., water) meter and/or a cloud-based server (e.g., a server of a utility company). If the functionality is distributed, software may reside on both the water meter and the server. FIGS. 1 and 2 show example controllers, processor, electronics, etc., by which the techniques of the example methods may be performed.

In other examples of the techniques discussed herein, the methods of operation may be performed by one or more application specific integrated circuits (ASIC) or may be performed by a general-purpose processor utilizing software defined in computer readable media. In the examples and techniques discussed herein, the memory 116 may comprise computer-readable media and may take the form of volatile memory, such as random-access memory (RAM) and/or non-volatile memory, such as read only memory (ROM) or flash RAM. Computer-readable media devices include volatile and non-volatile, removable, and non-removable media implemented in any method or technology for storage of information such as computer-readable instructions, data structures, program modules, or other data for execution by one or more processors of a computing device. Examples of computer-readable media include, but are not limited to, phase-change memory (PRAM), static random-access memory (SRAM), dynamic random-access memory (DRAM), other types of random access memory (RAM), read-only memory (ROM), electrically erasable programmable read-only memory (EEPROM), programmable read-only memory (PROM), flash memory or other memory technology, compact disk read-only memory (CD-ROM), digital versatile disks (DVD) or other optical storage, magnetic cassettes, magnetic tape, magnetic disk storage or other magnetic storage devices, or any other non-transitory medium that can be used to store information for access by a computing device.

As defined herein, computer-readable media includes non-transitory media. Computer-readable media does not include transitory media, such as modulated data signals and carrier waves, and/or other information-containing signals.

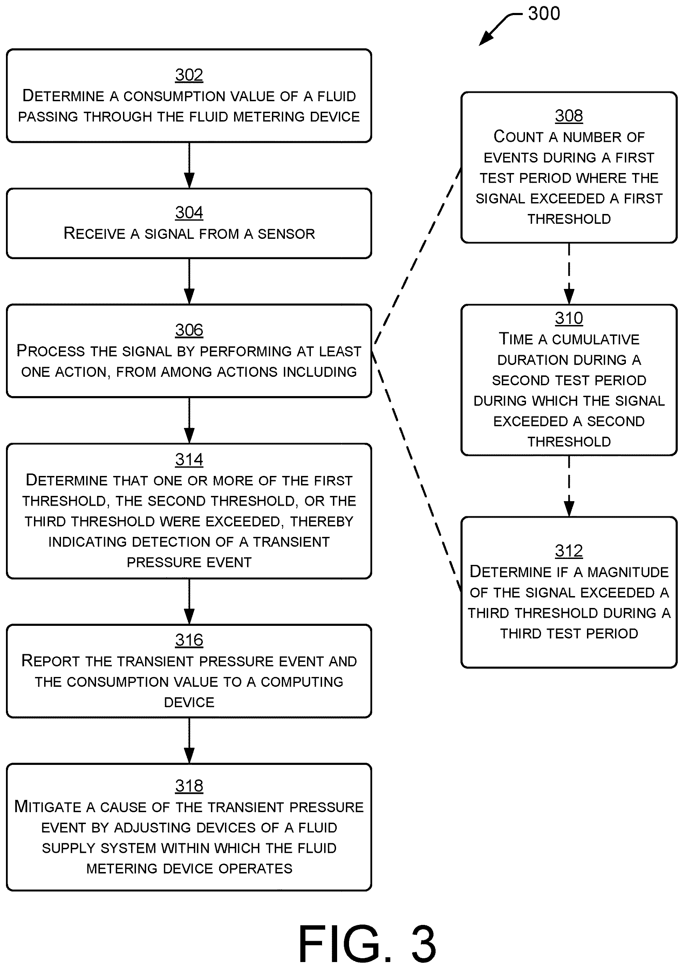

FIG. 3 shows example operation 300 of a water meter configured for the detection and measurement of transient pressure events. At block 302, a consumption value of a fluid passing through the fluid metering device is determined. At block 304, a signal is received from a sensor. At block 306, the signal may be processed by performing at least one action, from among actions including those described by blocks 308 through 312. At block 308, a number of events during a first test period-where the signal exceeded a first threshold-are counted. At block 310, a cumulative duration-during a second test period during which the signal exceeded a second threshold-is timed. At block 312, it is determined if a magnitude of the signal exceeded a third threshold during a third test period. At block 314, it is determined if one or more of the first threshold, the second threshold, or the third threshold were exceeded, thereby indicating detection of a transient pressure event. At block 316, the transient pressure event (and perhaps the consumption value) is reported to a computing device. In an example, consumption data is regularly transmitted to the server(s) 102. Data about one or more transient pressure events may be transmitted with the consumption data. At block 318, a cause of the transient pressure event is mitigated, such as by adjusting devices of a fluid supply system within which the fluid metering device operates. In an example, transient event damper or reducer is installed and/or turned on. In a second example, a speed of a pump sending water to the water meter may be adjusted to change more slowly. In a third example, a valve sending water to the water meter may be adjusted to open or close more slowly.

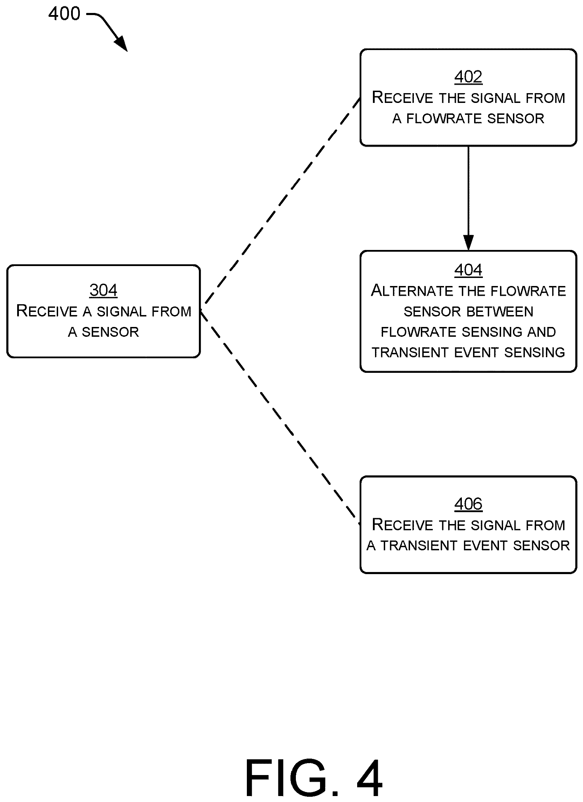

FIG. 4 shows alternative example techniques 400 by which different types of sensors may be used to perform transient pressure event sensing. Accordingly, the techniques 400 describe different systems and methods to produce the signal of block 304 of FIG. 3. One example includes generating a signal by operation of a flowrate sensor, while another example includes the use of a dedicated transient event sensor. Advantageously, the flowrate sensor is active several milliseconds per second detecting flowrate, and can be used to detect transient pressure events at other times. A flowrate sensor is a sensor that is used (at least part of the time) for flowrate sensing. Alternatively, a dedicated transient event sensor may require greater power during operation, but may be tuned or manufactured to better receive the frequency range of typical transient events. At block 402, a signal is received from a flowrate sensor. At block 404, the flowrate sensor is alternated between flowrate sensing and transient event sensing. Accordingly, the flowrate sensors perform a dual function of flowrate detection (as a part of water consumption measurement) and an additional function of detecting transient pressure event(s). In the alternative of block 406, the signal is received from a transient event sensor.

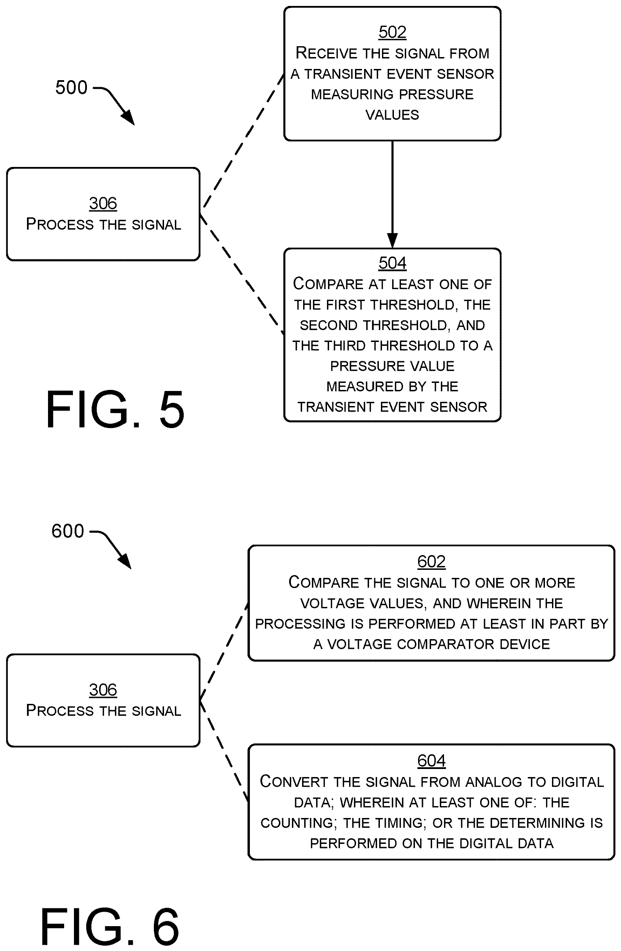

FIG. 5 shows example operation 500 of a metering device, wherein a transient event sensor is utilized to sense pressure values (e.g., absolute pressure values and/or relative (to atmospheric) pressure values), and to compare those values to values associated with threshold values of: a count of events; a duration of event(s); and/or a magnitude of events. In an alternative or alternative terminology, the transient event sensor may provide a "gauge" pressure, which is a difference between the absolute pressure and the atmospheric pressure. Accordingly, the transient event sensor provides additional information (e.g., not measured by the flowrate transducers) during a transient pressure event. In an example, the transient event sensor may be turned on after a transient event is detected in a signal of a flowrate sensor. The transient event sensor may be turned off after a threshold period of time has passed without further detection of a transient event. At block 306, a signal is processed. The signal is output by a transient event sensor (e.g., transient event sensor 222 of FIG. 2). At block 502, the signal is received from a transient event sensor measuring (absolute, relative to atmospheric, and/or gauge) pressure values. At block 504, the pressure value measured by the transient event sensor is compared to at least one of the first threshold, the second threshold, and the third threshold. In an example, the comparing may be performed according to the techniques and thresholds discussed with respect to blocks 308 through 312 in FIG. 3.

FIG. 6 shows example operation 600 of a metering device, wherein two techniques for signal processing are described. At block 306 of FIG. 3, a signal from a sensor is processed. Referring to FIG. 2, the signal may be output by one of the flowrate sensors 206, 210, or one of the transient event sensor 222, 226. Block 602 shows a first technique for signal processing, wherein the signal is compared to one or more voltage values. According to this technique, the processing is performed at least in part by a voltage comparator device. In some implementations, additional logic (e.g., counting circuits, timing circuits, an ASIC, etc.) may be used. At block 604, the signal is converted from analog to digital data. In an example of a technique involving an analog to digital conversion, the digital output is examined for at least one of: the counting; the timing; and/or the determining conditions described at blocks 308 through 312.

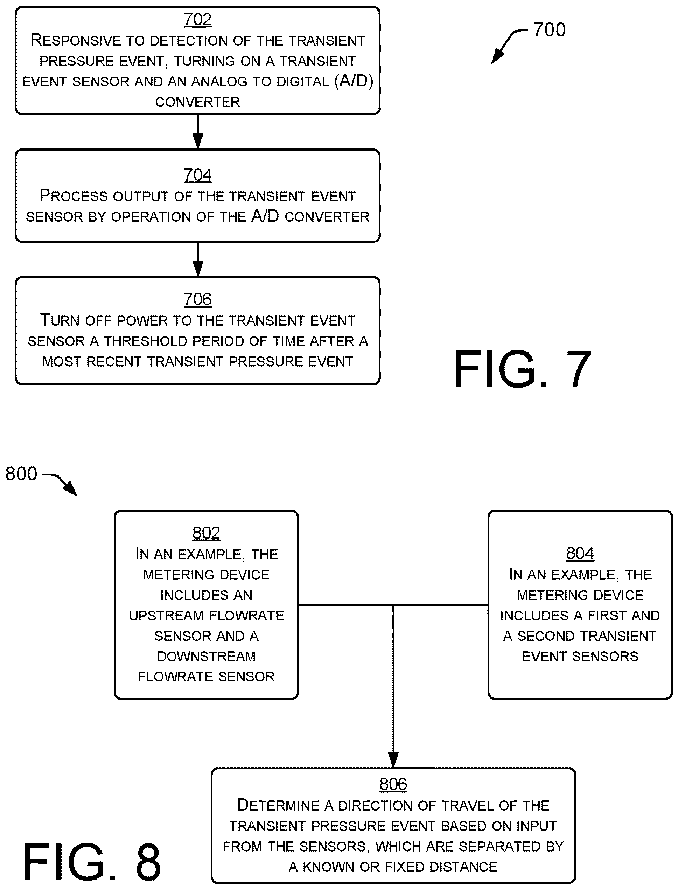

FIG. 7 shows example operation 700 of a metering device, wherein a transient signal sensor and associated logic are used to create and process a digital signal. At block 702, in response to detection of a transient pressure event, a transient event sensor and an analog to digital (A/D) converter are turned on. The detected transient event may have been detected by operation of a voltage comparator receiving a signal from a flowrate sensor. Following such a detection, it may be advantageous to turn on a transient event sensor, which is better suited to detect subsequent transient events at their typical frequencies. At block 704, the output of the transient event sensor is processed by operation of the A/D converter, to thereby produce digital data. Analysis of the digital data may be performed to recognize transient event(s). In an example, the digital data is processed by the processor 114 of FIG. 1, an ASIC device, and/or other logic circuits or programming. At block 706, power to the transient event sensor is turned off, such as after a threshold period of time following a most recent transient pressure event. Turning off the transient event sensor saves power. To continue to monitor for transient events, a flowrate sensor may provide a signal to a voltage comparator, such as during times when the flowrate sensor is not sensing flowrate.

FIG. 8 shows example operation 800 of a metering device, wherein two alternative techniques 802, 804 are described, which both utilize a common action (block 806) to determine a direction of travel of a transient signal. In the example involving the use of flowrate sensors of block 802, the metering device includes an upstream flowrate sensor and a downstream flowrate sensor. Information (e.g., two voltage signal) from the two sensors can be used to determine the direction of travel of a transient pressure event. In an example, FIG. 2 shows flowrate sensors 206, 210, which may be utilized to determine a direction of transient pressure event travel. In an alternative example seen at block 804, the metering device utilizes first and second transient event sensors to determine the direction of travel of a transient pressure event. In an example, FIG. 2 shows transient event sensors 222, 226, which may be utilized to determine a direction of transient pressure event travel. Both techniques share the action of block 806, wherein a direction of travel (and/or travel velocity) of the transient pressure event (high- or low-pressure pulse) is determined based on input from the sensors, which are separated by a known or fixed distance. In an example, either the upstream sensor (of either type) or the downstream sensor detects the transient pressure event first, thereby revealing its direction of travel.

### Example Systems, Devices, and Methods

The following examples of detection and measurement of transient pressure events are expressed as numbered clauses. While the examples illustrate a number of possible configurations and techniques, they are not meant to be an exhaustive listing of the systems, methods, and/or techniques described herein.
1. A metering device for use in a fluid supply system, comprising: a sensor; a processor; one or more memory devices, configured with programming executable by the processor; and a signal analyzer, configured to receive a signal from the sensor; wherein at least one of operation of the processor and operation of the signal analyzer detect a transient pressure event by determining at least one of: a number of events during a first test period where the signal exceeded a first threshold; a cumulative duration during a second test period during which the signal exceeded a second threshold; and if a magnitude of the signal exceeded a third threshold during a third test period.
2. The metering device as recited in clause 1, wherein: the sensor is a flowrate sensor; and the flowrate sensor alternates between flowrate sensing and transient event sensing.
3. The metering device as recited in clause 1 or 2, wherein: the sensor is a flowrate sensor; and the signal analyzer comprises a voltage comparator device.
4. The metering device as recited in any preceding clause, wherein: the sensor comprises a flowrate sensor; and the signal analyzer comprises: a digital to analog (A/D) converter to create digital data; and logic, to input the digital data, and to calculate one or more of: the number of events; the cumulative duration; and the magnitude.
5. The metering device as recited in any preceding clause, wherein: the signal analyzer comprises software defined on the one or more memory devices; or the signal analyzer comprises an application specific integrated circuit (ASIC) device.
6. The metering device as recited in any preceding clause, wherein: the sensor comprises a transient event sensor; and the signal analyzer comprises a voltage comparator device.
7. The metering device as recited in any preceding clause, wherein: the sensor comprises a transient event sensor; and the signal analyzer comprises an A/D converter and logic to perform actions, comprising at least one of: counting the number of events during the first test period where the signal exceeded the first threshold; timing the cumulative duration during the second test period during which the signal exceeded the second threshold; or determining if the magnitude of the signal exceeded the third threshold during the third test period.
8. The metering device as recited in any preceding clause, wherein: the processor performs actions, comprising at least one of: counting the number of events during the first test period where the signal exceeded the first threshold; timing the cumulative duration during the second test period during which the signal exceeded the second threshold; and determining if the magnitude of the signal exceeded the third threshold during the third test period.
9. The metering device as recited in any preceding clause, wherein: the sensor comprises a transient event sensor measuring pressure values (e.g., absolute pressure values and/or relative (to atmospheric pressure) pressure values); and at least one of the first threshold, the second threshold, and the third threshold is compared to (absolute, relative to atmospheric, and/or gauge) pressure values measured by the transient event sensor.
10. The metering device as recited in any preceding clause, wherein the sensor is a flowrate sensor, and wherein execution of the programming by the processor performs actions, comprising: responsive to detection of the transient pressure event, turning on a transient event sensor and an analog to digital (A/D) converter; processing output of the transient event sensor by operation of the A/D converter; and turning off power to the transient event sensor a threshold period of time after a most recent transient pressure event.
11. The metering device as recited in any preceding clause, wherein the metering device comprises an upstream flowrate sensor and a downstream flowrate sensor, and wherein execution of the programming by the processor performs actions, comprising: determining a direction of travel of the transient pressure event based on input from the upstream flowrate sensor and input from the downstream flowrate sensor.
12. The metering device as recited in any preceding clause, wherein the metering device comprises first and second transient event sensors, and wherein execution of the programming by the processor performs actions, comprising: determining a direction of travel of the transient pressure event based on input from the first and second transient event sensors.
13. The metering device as recited in any preceding clause, and wherein execution of the programming by the processor performs actions, comprising: reporting the transient pressure event to a remote server; and mitigating a cause of the transient pressure event by adjusting devices of the fluid supply system.
14. The metering device as recited in any preceding clause, and wherein execution of the programming by the processor performs actions, comprising: reporting the transient pressure event to a remote server; and mitigating a cause of the transient pressure event by turning on a transient pressure mitigating device.
   The metering device as recited in the independent clause, additionally comprising one or more or all of any of the preceding clauses.
15. A method of operating a fluid metering device, comprising: determining a consumption value of a fluid passing through the fluid metering device; receiving a signal from a sensor; processing the signal by performing at least one action, from among actions comprising: counting a number of events during a first test period where the signal exceeded a first threshold; timing a cumulative duration during a second test period during which the signal exceeded a second threshold; and determining if a magnitude of the signal exceeded a third threshold during a third test period; and determining that one or more of the first threshold, the second threshold, or the third threshold were exceeded, thereby indicating detection of a transient pressure event.
16. The method of clause 15, wherein: receiving the signal from the sensor comprises receiving the signal from a flowrate sensor; alternating the flowrate sensor between flowrate sensing and transient event sensing.
17. The method of clause 15 or 16, wherein: receiving the signal from the sensor comprises receiving the signal from a flowrate sensor; and processing the signal comprises comparing the signal to one or more voltage values, and wherein the processing is performed at least in part by a voltage comparator device.
18. The method of any of clauses 15 to 17, wherein: receiving the signal comprises receiving the signal from a transient event sensor; and processing the signal comprises: converting the signal from analog to digital data; wherein at least one of: the counting; the timing; or the determining is performed on the digital data.
19. The method of any of clauses 15 to 18, wherein: receiving the signal comprises receiving the signal from a transient event sensor measuring (absolute, relative to atmospheric, and/or gauge) pressure values; and at least one of the first threshold, the second threshold, and the third threshold is compared to an (absolute, relative to atmospheric, and/or gauge) pressure value measured by the transient event sensor.
20. The method of any of clauses 15 to 19, additionally comprising: reporting the transient pressure event and the consumption value to a computing device; and mitigating a cause of the transient pressure event by adjusting devices of a fluid supply system within which the fluid metering device operates.

The method as recited in the independent clause, additionally comprising one or more or all of any of the preceding clauses.

### Conclusion

Although the subject matter has been described in language specific to structural features and/or methodological actions, it is to be understood that the subject matter defined in the appended claims is not necessarily limited to the specific features or actions described. Rather, the specific features and actions are disclosed as exemplary forms of implementing the claims.

The words comprise, comprises, and/or comprising, when used in this specification and/or claims do not preclude the presence or addition of one or more other features, devices, techniques, and/or components and/or groups thereof.

## Claims

1. A metering device for use in a fluid supply system, comprising:
a sensor;
a processor;
one or more memory devices, configured with programming executable by the processor; and
a signal analyzer, configured to receive a signal from the sensor;
wherein at least one of operation of the processor and operation of the signal analyzer detect a transient pressure event by determining at least one of:
a number of events during a first test period where the signal exceeded a first threshold;
a cumulative duration during a second test period during which the signal exceeded a second threshold; and
if a magnitude of the signal exceeded a third threshold during a third test period.

2. The metering device as recited in claim 1, wherein:
the sensor is a flowrate sensor; and
the flowrate sensor alternates between flowrate sensing and transient event sensing; and/or
the signal analyzer comprises a voltage comparator device.

3. The metering device as recited in claim 1 or 2, wherein:
the sensor comprises a flowrate sensor; and
the signal analyzer comprises:
a digital to analog (A/D) converter to create digital data; and
logic, to input the digital data, and to calculate one or more of: the number of events; the cumulative duration; and the magnitude.

4. The metering device as recited in any preceding claim, wherein:
the signal analyzer comprises software defined on the one or more memory devices; or
the signal analyzer comprises an application specific integrated circuit (ASIC) device.

5. The metering device as recited in any preceding claim, wherein:
the sensor comprises a transient event sensor; and
the signal analyzer comprises a voltage comparator device; and/or
the signal analyzer comprises an A/D converter and logic to perform actions, comprising at least one of:
counting the number of events during the first test period where the signal exceeded the first threshold;
timing the cumulative duration during the second test period during which the signal exceeded the second threshold; or
determining if the magnitude of the signal exceeded the third threshold during the third test period.

6. The metering device as recited in any preceding claim, wherein:
the processor performs actions, comprising at least one of:
counting the number of events during the first test period where the signal exceeded the first threshold;
timing the cumulative duration during the second test period during which the signal exceeded the second threshold; and
determining if the magnitude of the signal exceeded the third threshold during the third test period.

7. The metering device as recited in any preceding claim, wherein:
the sensor comprises a transient event sensor measuring pressure values; and
at least one of the first threshold, the second threshold, and the third threshold is compared to pressure values measured by the transient event sensor.

8. The metering device as recited in any preceding claim, wherein the sensor is a flowrate sensor, and wherein execution of the programming by the processor performs actions, comprising:
responsive to detection of the transient pressure event, turning on a transient event sensor and an analog to digital (A/D) converter;
processing output of the transient event sensor by operation of the A/D converter; and
turning off power to the transient event sensor a threshold period of time after a most recent transient pressure event.

9. The metering device as recited in any preceding claim, wherein the metering device comprises an upstream flowrate sensor and a downstream flowrate sensor, and wherein execution of the programming by the processor performs actions, comprising:
determining a direction of travel of the transient pressure event based on input from the upstream flowrate sensor and input from the downstream flowrate sensor.

10. The metering device as recited in any preceding claim, wherein the metering device comprises first and second transient event sensors, and wherein execution of the programming by the processor performs actions, comprising:
determining a direction of travel of the transient pressure event based on input from the first and second transient event sensors.

11. The metering device as recited in any preceding claim, and wherein execution of the programming by the processor performs actions, comprising:
reporting the transient pressure event to a remote server; and
mitigating a cause of the transient pressure event by adjusting devices of the fluid supply system; and/or
mitigating a cause of the transient pressure event by installing or turning on a transient pressure mitigating device.

12. A method of operating a fluid metering device, comprising:
determining a consumption value of a fluid passing through the fluid metering device;
receiving a signal from a sensor;
processing the signal by performing at least one action, from among actions comprising:
counting a number of events during a first test period where the signal exceeded a first threshold;
timing a cumulative duration during a second test period during which the signal exceeded a second threshold; and
determining if a magnitude of the signal exceeded a third threshold during a third test period; and
determining that one or more of the first threshold, the second threshold, or the third threshold were exceeded, thereby indicating detection of a transient pressure event.

13. The method of claim 12, wherein:
receiving the signal from the sensor comprises receiving the signal from a flowrate sensor;
alternating the flowrate sensor between flowrate sensing and transient event sensing and/or
processing the signal comprises comparing the signal to one or more voltage values, and wherein the processing is performed at least in part by a voltage comparator device.

14. The method of claim 12 or 13, wherein:
receiving the signal comprises receiving the signal from a transient event sensor; and
processing the signal comprises:
converting the signal from analog to digital data;
wherein at least one of: the counting; the timing; or the determining is performed on the digital data.

15. The method of any of claims 12 to 14, wherein:
receiving the signal comprises receiving the signal from a transient event sensor measuring pressure values; and
at least one of the first threshold, the second threshold, and the third threshold is compared to a pressure value measured by the transient event sensor; and/or
the method additionally comprising:
reporting the transient pressure event and the consumption value to a computing device; and
mitigating a cause of the transient pressure event by adjusting devices of a fluid supply system within which the fluid metering device operates.
